# EUROPEAN PATENT APPLICATION

(11) **EP 2 763 057 A1**
(43) Date of publication of application: **06.08.2014**
(21) Application number: 12837564.9
(22) Date of filing: 24.08.2012
(51) Int. Cl.: G06F 17/50, B64F 5/00

(54) **AIRPLANE DESIGN DEVICE, AIRPLANE DESIGN PROGRAM, AND AIRPLANE DESIGN METHOD**

(30) Priority: 29.09.2011 JP 2011214633
(71) Applicant: Mitsubishi Heavy Industries, Ltd., Tokyo 108-8215 (JP)
(72) Inventor: TAKAMI, Hikaru, Tokyo 108-8215 (JP); SAKAKI, Kensuke, Tokyo 108-8215 (JP); HATSUDA, Jiro, Tokyo 108-8215 (JP)
(74) Representative: Desormiere, Pierre-Louis
(86) International application number: PCT/JP2012/071401
(87) International publication number: WO 2013/047038

(57) **Abstract**

An aircraft design apparatus calculates aircraft specifications, which are aircraft specifications, based on a plurality of design parameters required to design an aircraft; judges whether or not the calculated aircraft specifications meet constraints that indicate the aircraft feasibility and that are set in advance and given optimizing conditions for optimizing the aircraft; changes the design parameters so that the calculated aircraft specifications meet the constraints and also meet the optimizing conditions; and executes iterative processing in which the aircraft specifications are repeatedly calculated based on the changed design parameters. By doing so, with the aircraft design apparatus, it is possible to achieve a more optimal aircraft design and it is also possible to reduce the time and effort required to design an aircraft.

## Description

### {Technical Field}

The present invention relates to an aircraft design apparatus, an aircraft design program, and an aircraft design method.

### {Background Art}

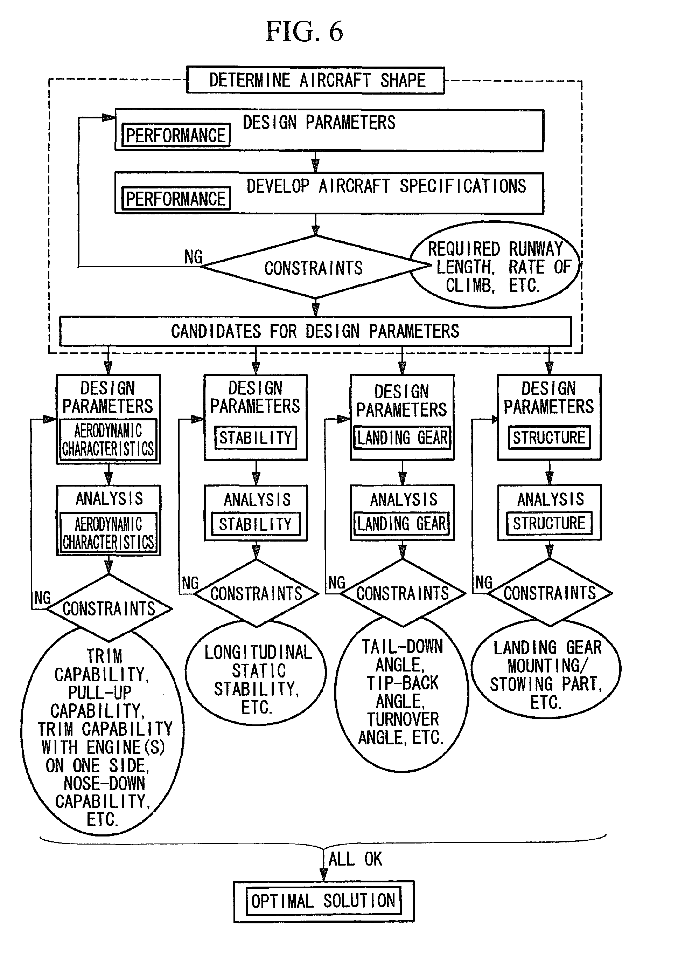

Conventionally, when engineers design an entire aircraft (total aircraft design), a final solution has been obtained by, for example, performing the work shown in the conceptual diagram in Fig. 6.

First, a performance engineer selects design parameters related to performance and develops aircraft specifications that meet constraints related to performance, thus selecting provisional candidates for the design parameters to be used in areas not related to performance (aerodynamic characteristics, stability, landing gear, structure, etc.). In this case, when developing the aircraft specifications, design parameters of areas not related to performance are not accounted for or, even if they are accounted for, the design parameters of areas not related to performance are set to take fixed values provisionally determined with reference to design examples or the like of other aircraft. Note that the shape of an aircraft is roughly determined by this selection of candidates for these design parameters.

Next, for areas not related to performance, engineers in charge of individual areas judge whether or not the above-described selected candidates for the design parameters meet constraints for the individual areas. In the case in which the constraints are not met, the candidates for the design parameters are reselected for each area, and it is judged again whether or not the constraints in each area are met.

In conventional aircraft design, a final solution has been obtained by repeating the above-described processes until the constraints of the individual areas are met.

In addition, Patent Literature 1 discloses a design method which is an optimizing program that employs a genetic algorithm (Genetic Algorithm: GA) in a method of optimizing the design of rotor blades of a helicopter, in which parameters representing the airfoil are used as design parameters, a plurality of required performance levels are set in objective functions, and computational fluid dynamics calculations are performed with these calculation conditions, thus deriving an optimal rotor-blade airfoil by performing multi-objective optimization calculations.

### {Citation List}

### {Patent Literature}

{PTL 1} Japanese Unexamined Patent Application, Publication No. 2008-90548 {Summary of Invention}

### {Technical Problem}

With the conventional aircraft design method shown in Fig. 6, a feasible aircraft is established by using a final solution that meets all constraints in the individual areas. However, with the conventional aircraft design method, it is possible that the aircraft as a whole is not fully optimized because the design values finally selected in the individual areas are not mutually related to the design values selected in other areas.

On the other hand, the design method disclosed in Patent Literature 1 can be employed when designing an airfoil. However, in the case in which the entire aircraft is designed, in addition to requiring knowledge about aircraft aerodynamics, various knowledge and experience related to aircraft, such as performance, structure, landing gear, stability, etc., are required; in other words, because many experts need to be involved, the entire aircraft cannot be designed with the design method disclosed in Patent Literature 1 alone.

The present invention has been conceived in light of the above-described circumstances, and an object thereof is to provide an aircraft design apparatus, an aircraft design program, and an aircraft design method with which it is possible to achieve a more optimal aircraft design and with which it is also possible to reduce the time and effort required to design an aircraft.

### {Solution to Problem}

In order to solve the above-described problems, an aircraft design apparatus, an aircraft design program, and an aircraft design method of the present invention employ the following solutions.

An aircraft design apparatus according to a first aspect of the present invention includes a calculating means that calculates aircraft specifications, which are aircraft specifications, based on a plurality of design parameters required to design an aircraft; a first judging means that judges whether or not the aircraft specifications calculated by the calculating means meet given constraints; a second judging means that judges whether or not the aircraft specifications calculated by the calculating means meet given optimizing conditions for optimizing the aircraft; and a changing means that changes the design parameters, wherein iterative processing is executed, in which the design parameters are repeatedly changed by the changing means and the aircraft specifications are repeatedly calculated by the calculating means based on the design parameters so that the aircraft specifications calculated by the calculating means meet the constraints and also meet the optimizing conditions.

With this configuration, the aircraft specifications, which are aircraft specifications, are calculated by the calculating means based on the plurality of design parameters required to design an aircraft; whether or not the calculated aircraft specifications meet the given constraints is judged by the first judging means; and whether or not the calculated aircraft specifications meet the given optimizing conditions for optimizing the aircraft is judged by the second judging means. Note that the constraints are conditions indicating the aircraft feasibility.

Specifically, with this configuration, aircraft specifications that meet the constraints and that also meet the optimizing conditions are calculated.

Then, with the iterative processing, the design parameters are repeatedly changed by the changing means and the aircraft specifications are repeatedly calculated by the calculating means based on the design parameters so that the calculated aircraft specifications meet the constraints and also meet the optimizing conditions.

Specifically, with this configuration, when calculation results that do not meet the constraints or the optimizing conditions are obtained, all design parameters are changed instead of changing only specific design parameters. Accordingly, designing in individual areas is not performed independently in such a way that constraints are separately met in the individual areas related to the aircraft design, as has conventionally been done, and therefore, the aircraft specifications obtained by this configuration take values that are mutually related among the individual areas.

In addition, with this configuration, even if aircraft specifications that meet all constraints are calculated, the aircraft specifications are recalculated from the beginning by changing the design parameters, and new aircraft specifications are calculated until conditions for ending optimizing processing are met.

With the above-described processes, this configuration makes it possible to achieve a more optimal aircraft design. In addition, because an information processing device performs processing with the individual means described above, this configuration makes it possible to reduce the time and effort required to design an aircraft.

In addition, with the above-described first aspect, it is preferable that the first judging means judge whether or not constraints related to performance, aerodynamic characteristics, stability, landing gear, and structure of the aircraft are met.

With this configuration, since constraints accounted for in an aircraft design are comprehensively included, it is possible to achieve a realistic aircraft design.

In addition, with the above-described first aspect, it is preferable that the changing means change the design parameters so as to meet the optimizing conditions based on calculation results of the aircraft specifications that have previously been calculated by the calculating means.

With this configuration, because the design parameters are changed based on the calculation results of the aircraft specifications that have previously been calculated, the design parameters can be changed to more appropriate values as the number of calculation results of the aircraft specifications increases.

In addition, with the above-described first aspect, it is preferable that the calculating means calculate the aircraft specifications for a plurality of individuals each time the aircraft specifications are calculated.

With this configuration, because the calculating means calculates the aircraft specifications for the plurality of individuals each time the aircraft specifications are calculated, it is possible to achieve an optimal overall aircraft design with greater precision, even if the iterative processing is performed a small number of times.

An aircraft design program according to a second aspect of the present invention causes a computer to function as a calculating means that calculates aircraft specifications, which are aircraft specifications, based on a plurality of design parameters required to design an aircraft; a first judging means that judges whether or not the aircraft specifications calculated by the calculating means meet given constraints; a second judging means that judges whether or not the aircraft specifications calculated by the calculating means meet given optimizing conditions for optimizing the aircraft; and a changing means that changes the design parameters, wherein iterative processing is executed, in which the design parameters are repeatedly changed by the changing means and the aircraft specifications are repeatedly calculated by the calculating means based on the design parameters so that the aircraft specifications calculated by the calculating means meet the constraints and also meet the optimizing conditions.

An aircraft design method according to a third aspect of the present invention includes a first step of calculating aircraft specifications, which are aircraft specifications, based on a plurality of design parameters required to design an aircraft; a second step of judging whether or not the calculated aircraft specifications meet given constraints and given optimizing conditions for optimizing the aircraft; and a third step of changing the design parameters so that the calculated aircraft specifications meet the constraints and also meet the optimizing conditions, wherein iterative processing in which the aircraft specifications are repeatedly calculated based on the changed design parameters is executed.

### {Advantageous Effects of Invention}

The present invention affords the excellent advantages that it is possible to achieve a more optimal aircraft design and it is also possible to reduce time and effort required to design an aircraft.

### {Brief Description of Drawings}

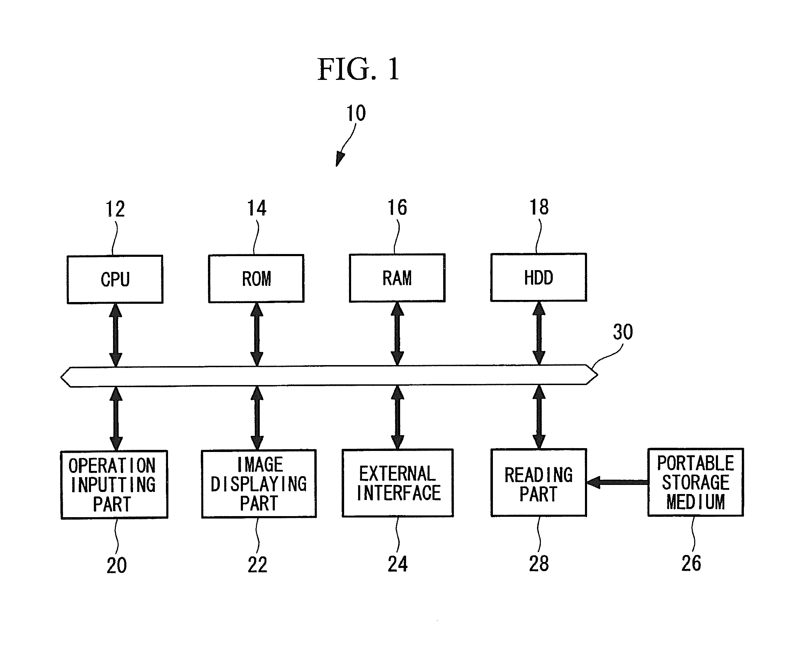

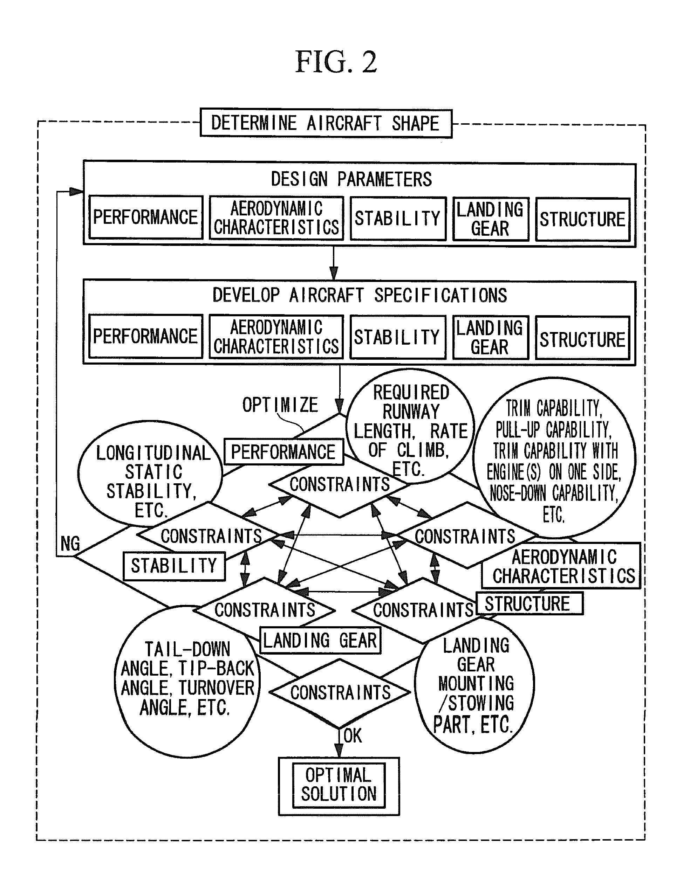

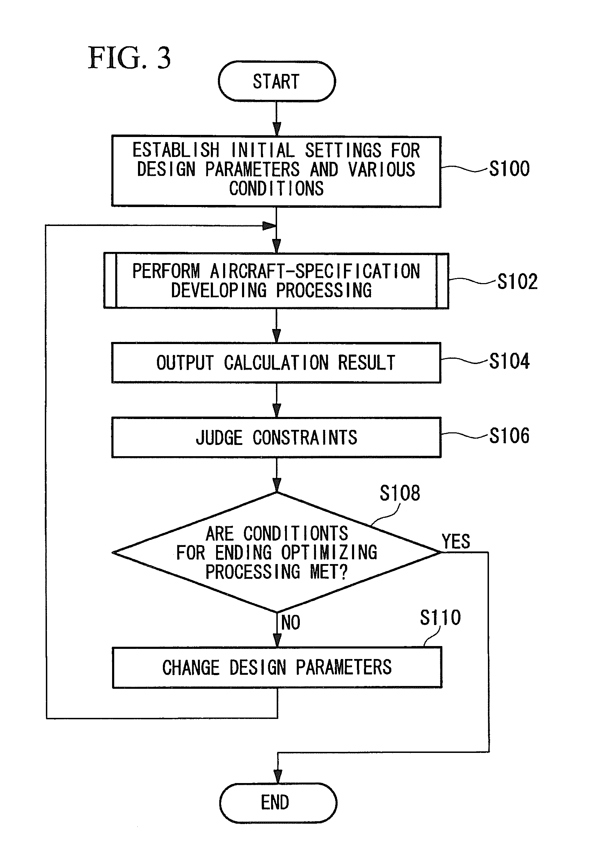

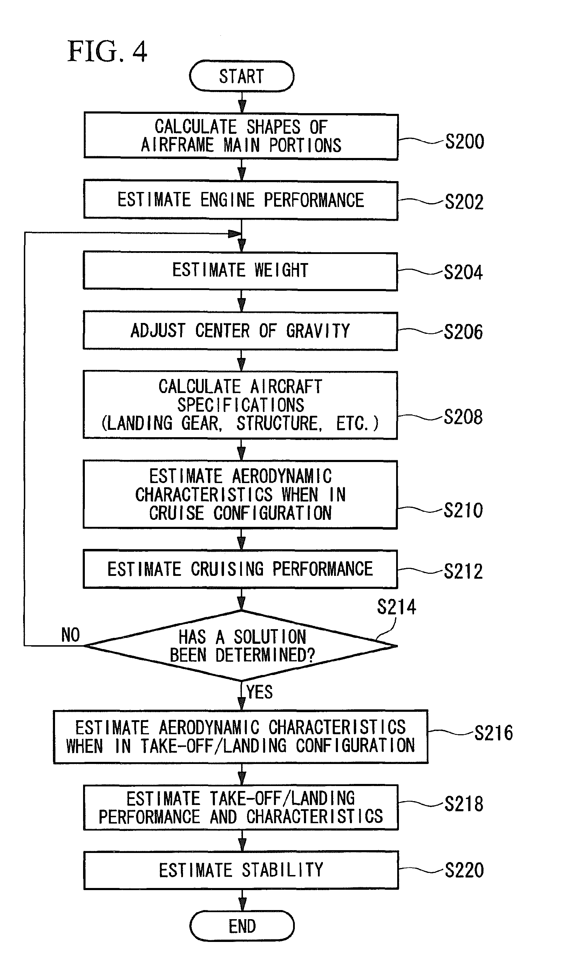

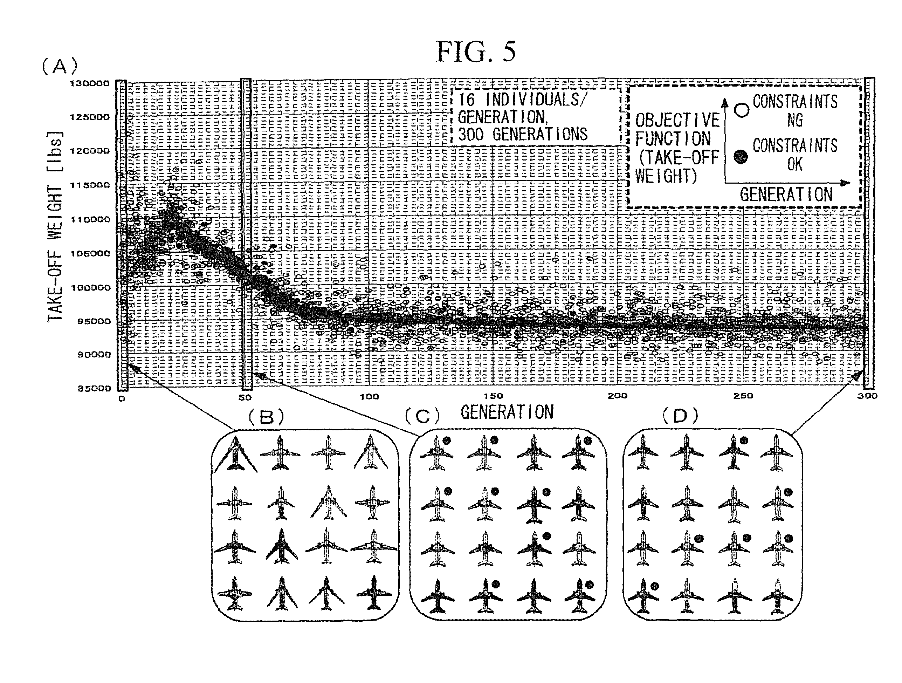

{Fig. 1} Fig. 1 is a block diagram showing the electrical configuration of an aircraft design apparatus according to an embodiment of the present invention.
{Fig. 2} Fig. 2 is a conceptual diagram of an aircraft design method according to the embodiment of the present invention.
{Fig. 3} Fig. 3 is a flowchart showing the processing flow of an aircraft design program according to the embodiment of the present invention.
{Fig. 4} Fig. 4 is a flowchart showing the flow of aircraft-specification developing processing according to the embodiment of the present invention.
{Fig. 5} Fig. 5 is a diagram showing example calculation results of aircraft design processing according to the embodiment of the present invention, showing (A) a graph indicating the take-off weight of an aircraft calculated for each generation, (B) the aircraft shapes calculated for the first generation, (C) the aircraft shapes calculated for the 50th generation, and (D) the aircraft shapes calculated for the 300th generation.
{Fig. 6} Fig. 6 is a conceptual diagram of a conventional aircraft design method.

### {Description of Embodiment}

An embodiment of an aircraft design apparatus, an aircraft design program, and an aircraft design method according to the present invention will be described below with reference to the drawings.

Fig. 1 shows the electrical configuration of an aircraft design apparatus 10 according to this embodiment. The aircraft design apparatus 10 is an information processing device for designing the entire aircraft (whole aircraft).

The aircraft design apparatus 10 is provided with a CPU (Central Processing Unit) 12 that controls the operation of the aircraft design apparatus 10 as a whole, a ROM (Read Only Memory) 14 in which various programs or the like are stored in advance, a RAM (Random Access Memory) 16 used as a work area or the like when the CPU 12 executes various programs, and an HDD (Hard Disk Drive) 18 that serves as a storing means for storing various programs such as an aircraft design program etc., the details of which will be described below, and various information.

Furthermore, the aircraft design apparatus 10 is provided with an operation inputting part 20 that is constituted of a keyboard, a mouse, or the like and that receives inputs of various operations; an image displaying part 22 that displays various images such as images for prompting the input of various information, images indicating results of aircraft design processing, etc.; an external interface 24 that is connected to external devices, such as a printer, other information processing devices, etc., and that transmits/receives various information to/from the external devices; and a reading part 28 that reads out information stored in a portable storage medium 26. Note that the portable storage medium 26 includes a magnetic disk, an optical disc such as a CD (Compact Disc), a DVD (Digital Versatile Disc), etc., an IC (Integrated Circuit) card, a memory card, or the like.

The CPU 12, the ROM 14, the RAM 16, the HDD 18, the operation inputting part 20, the image displaying part 22, the external interface 24, and the reading part 28 are electrically connected with each other via a system bus 30. Therefore, the CPU 12 can individually access the ROM 14, the RAM 16, and the HDD 18, ascertain the operating state of the operation inputting part 20, display various images on the image displaying part 22, transmit/receive various information to/from the above-described external devices via the external interface 24, read out information from the portable storage medium 26 via the reading part 28, and so on.

Next, an aircraft design method according to this embodiment, in other words, aircraft design processing executed in the aircraft design apparatus 10 will be described by using a conceptual diagram in Fig. 2.

With the aircraft design processing according to this embodiment, first, design parameters required to design an aircraft are set. The set design parameters are used to calculate aircraft specifications, which are aircraft specifications (hereinafter referred to as "aircraft-specification development"). Specific examples of the design parameters include parameters related to aircraft performance (maximum engine output, main-wing area, main-wing aspect ratio, etc.), parameters related to aerodynamics and stability of an aircraft (vertical stabilizer area, horizontal stabilizer area, etc.), and parameters related to landing gear, structure, etc.

Note that the aircraft specifications discussed here include aircraft performance, aircraft characteristics (aerodynamic characteristics, stability, etc.), specifications of aircraft landing gear, aircraft structure (shape, weight, etc.), etc.

In the processing that follows, the aircraft specifications are calculated by performing the aircraft-specification development based on the set design parameters.

In the processing that follows, it is judged whether or not the calculated aircraft specifications meet given constraints. Note that the constraints are conditions that indicate the aircraft feasibility, for example, required runway length, rate of climb, etc. with regard to performance, trim capability, pull-up capability, trim capability with engine(s) on one side, nose-down capability, etc. in terms of aerodynamic characteristics; longitudinal static stability, etc. in terms of stability; mounting and stowing positions of landing gear (landing-gear mounting/stowing positions), etc. in terms of structure; and tail-down angle, tip-back angle, turnover angle, etc. in terms of landing gear.

In addition, in the above-described processing, it is judged whether or not the aircraft specifications meet given optimizing conditions for optimizing an aircraft is judged. Note that the targets of the optimizing conditions (hereinafter referred to as "optimization targets") are, for example, airframe weight, operating cost of the aircraft, number of passengers the aircraft can accommodate, etc.

Then, in the aircraft design processing according to this embodiment, iterative processing is executed, in which the design parameters are repeatedly changed and the aircraft specifications are repeatedly calculated based on the design parameters so that the calculated aircraft specifications meet the constraints and also meet the optimizing conditions.

Specifically, with the aircraft design processing according to this embodiment, when calculation results that do not meet the constraints or the optimizing conditions are obtained, all design parameters are changed instead of changing only specific design parameters. Accordingly, designing in individual areas is not performed independently in such a way that constraints are separately met in the individual areas related to the aircraft design, as has conventionally been done, and therefore, the aircraft specifications obtained by the aircraft design processing according to this embodiment take values that are mutually related among the individual areas.

In addition, with the aircraft design processing according to this embodiment, even if aircraft specifications that meet all constraints are calculated, the aircraft specifications are recalculated from the beginning by changing the design parameters and a plurality of new aircraft specifications are calculated until conditions for terminating optimizing processing are met.

An engineer selects, together with the calculated design parameters, the aircraft specifications that meet the constraints and the optimizing conditions, obtained by means of such aircraft design processing, and employs these aircraft specifications as design values.

Fig. 3 is a flowchart showing the processing flow of an aircraft design program executed on the aircraft design apparatus 10 in the case in which the aircraft design processing is performed, and the aircraft design program is stored in a predetermined region of the HDD 18 in advance. Note that the aircraft design program is started when a start instruction is input by the engineer via the operation inputting part 20.

First, in Step 100, initial settings are established for the main design parameters for an airframe and for various conditions. Note that, in this Step 100, the main design parameters for an airframe and various conditions input by the engineer via the operation inputting part 20 are received when starting this program. Note that, in addition to the constraints and the optimizing conditions, various conditions include a maximum number of times the iterative processing is performed (for example, 300 times), the number of individuals (patterns) of the aircraft specifications to be calculated each time the aircraft-specification development is performed (for example, 16), etc.

Note that the design parameters and various conditions may be stored in the HDD 18 in advance and they may be set by reading out the stored design parameters and various conditions.

In Step 102 that follows, aircraft-specification developing processing for calculating the aircraft specifications is executed. The details of the aircraft-specification developing processing will be described later by using a flowchart shown in Fig. 4.

In Step 104 that follows, calculation results of the aircraft-specification developing processing (calculated aircraft specifications) are output together with the design parameters used in the aircraft-specification developing processing. Note that the output described here involves storing the calculation results in a predetermined region of the HDD 18.

In Step 106 that follows, the aircraft specifications calculated by the aircraft-specification developing processing are read out from the HDD 18, and constraining-condition judging processing for judging whether or not the constraints are met is executed. Note that the judgment results of the constraining-condition judging processing are stored in the HDD 18 in association with the calculation results of the aircraft-specification developing processing and the design parameters.

In Step 108 that follows, it is judged whether or not the conditions for ending the optimizing processing are met, and this program is ended in the case of an affirmative judgment, whereas the program proceeds to Step 110 in the case of a negative judgment. Note that the details of the conditions for ending the optimizing processing will be described later.

In Step 110, the design parameters are changed, and the aircraft-specification developing processing in Step 102 is re-executed. Specifically, in Step 110, the design parameters are changed based on the calculation results of the aircraft-specification developing processing that has previously been executed so that a solution that meets both the constraints and the optimizing conditions is obtained.

The design parameters are changed in Step 110 by using, for example, a genetic algorithm (Genetic Algorithm: GA). The genetic algorithm changes the design parameters by means of manipulations such as selection, crossover, mutation, etc. so that the constraints are met and so that values of the optimization targets are also optimized.

Note that concrete changes of the design parameters will be described later by using Fig. 5.

Then, once changed values of the design parameters are determined, the program returns to Step 102. In Step 102, the aircraft-specification developing processing is re-executed by using the changed design parameters.

In this way, the aircraft design processing according to this embodiment develops the aircraft specifications by means of the aircraft-specification developing processing, and repeats the aircraft-specification developing processing while changing the design parameters until the constraints are met and the conditions for ending the optimizing processing are also met.

Fig. 4 is a flowchart showing the flow of the aircraft-specification developing processing executed in Step 102 of the aircraft design processing. In the aircraft-specification developing processing, aircraft performance, aircraft flying characteristics, specifications of aircraft landing gear, and aircraft structure, which are included in the aircraft-specification development of the aircraft design method shown in the conceptual diagram in Fig. 2, are estimated.

First, in Step 200, airframe-shape parameters, which indicate detailed shapes (including characteristic quantities) of main portions of an airframe (main wings, stabilizers, a fuselage, engine nacelles, etc.), are calculated based on the design parameters.

In Step 202 that follows, the engine performance is estimated based on the design parameters and the detailed shape etc. of the engine nacelles included in the calculation results of the airframe-shape parameters calculated in Step 200.

Then, in the subsequent steps, aircraft specifications to be optimized are calculated based on the airframe-shape parameters calculated in Step 200, the engine performance estimated in Step 202, etc. The calculation of the aircraft specifications is performed by, for example, solving non-linear functions that define the relationships among the aircraft specifications.

In Step 204, weights of individual portions (main wings, stabilizers, fuselage, etc.) and sub-systems (steering system, landing gear system, air-conditioning system, hydraulic system, electrical system, etc.) of the aircraft are estimated based on the parameters such as the airframe-shape parameters calculated in Step 200 etc.

As a concrete example of calculation of the weight of the aircraft based on the parameters such as the detailed shape of the airframe etc., the weight is estimated based on the parameters such as the airframe-shape parameters calculated in Step 200 etc. by using weight statistics or the like that summarize the relationships between main design parameters (wing area, wing thickness, etc. in the case of estimating the weights of main wings) and weights.

In Step 206 that follows, the center of gravity is adjusted by adjusting the positional relationship of the individual components of the aircraft so that the center of gravity of the aircraft is set at a predetermined position. Note that, in the case in which a negative judgment is obtained in Step 214, described later, and the processing in Step 206 is performed again, because the aircraft specifications change every cycle and the weights of the individual components and the sub-systems of the airframe change in a corresponding manner, the center of gravity is adjusted each time by adjusting the mutual positions of the individual components of the airframe.

In Step 208 that follows, the aircraft specifications (specifications of landing gear, various structures, etc.; tail-down angle, tip-back angle, turnover angle, a landing gear mounting/stowing position, etc. that change depending on the positional relationship between the main wings and the fuselage) that can be determined by calculating the aircraft parameters and by adjusting the center of gravity are calculated.

In Step 210 that follows, aerodynamic characteristics of the aircraft in cruise configuration and aerodynamic characteristics required for calculating the aerodynamic balance in the cruise configuration are estimated based on the airframe shape calculated in Step 208. Note that, in the case in which a negative judgment is obtained in Step 214, described later, and the processing in Step 210 is performed again, because the airframe shape changes every cycle in association with the adjustment of the center of gravity performed in Step 206, aerodynamic characteristics for the changed airframe shape, including the rudder effectiveness, are estimated.

In Step 212 that follows, the cruising performance of the aircraft is estimated based on the estimated aerodynamic characteristics of the aircraft in the cruise configuration, the aerodynamic balance when cruising, and the engine performance. Note that, in the case in which a negative judgment is obtained in Step 214, described later, and the processing in Step 212 is performed again, because the aerodynamic characteristics of the aircraft change every cycle, the aerodynamic balance of the aircraft is calculated every cycle, and the fuel consumption is estimated based on the results of the balance calculation.

In Step 214 that follows, it is judged whether or not the solution of the non-linear function has been determined, and the process proceeds to Step 216 in the case of an affirmative judgment, whereas in the case of a negative judgment, the process returns to Step 204, and the processing from Step 204 to Step 214 is repeated until the solution is determined.

In Step 216 that follows, aerodynamic characteristics of the aircraft in a take-off/landing configuration are estimated, including aerodynamic characteristics required for calculating the aerodynamic balance in the take-off/landing configuration.

In Step 218 that follows, the aircraft performance (required runway length, rate of climb, etc.) and the aerodynamic characteristics (trim capability, pull-up capability, trim capability with engine(s) on one side, nose-down capability, etc.) are estimated based on the aerodynamic characteristics in the take-off/landing configuration, the weight, the engine performance, etc. of the aircraft. In more detail, the aerodynamic balance of the aircraft is estimated, including the aerodynamic effects of aerodynamic devices such as leading-edge flaps, trailing-edge flaps, elevators, the rudder, etc., and the aircraft performance and the aerodynamic characteristics are estimated based on the estimation results of the aerodynamic balance.

In Step 220 that follows, the aircraft stability (longitudinal static stability, etc.) is estimated. In more detail, the aircraft stability is estimated based on the aerodynamic characteristics of the aircraft, including the aerodynamic effects of the aerodynamic devices such as the leading-edge flaps, the trailing-edge flaps, the elevators, the rudder, etc.

Note that, by ending the aircraft-specification developing processing together with ending of the processing in Step 220, the aircraft design processing proceeds to Step 104 of the aircraft design processing shown in Fig. 3.

Fig. 5 is a diagram showing example calculation results of the aircraft design processing according to this embodiment, in other words, a diagram showing results of the processing according to Step 108 in Fig. 3, which are calculation results for the case in which GA is employed as an optimizing method, in which the aircraft specifications for a plurality of individuals (16 individuals) are calculated each time (generation) the aircraft-specification developing processing is performed, and in which the iterative processing is performed 300 times (generations).

Note that, in an example in Fig. 5, a case in which predetermined optimizing conditions are used will be described, where the optimizing condition is, for example, "for the weight of the aircraft, including the weight of aircraft fuel (hereinafter referred to as "take-off weight"), to achieve a lighter take-off weight".

Note that, with the aircraft design processing according to this embodiment, in order to calculate the aircraft specifications for a plurality of individuals each time the aircraft-specification developing processing is performed, for example, a predetermined allowance is given to the design parameters used in the aircraft-specification developing processing and the design parameters are set in a plurality of patterns within the range of that allowance. Then, with the aircraft design processing according to this embodiment, the aircraft specifications for the plurality of individuals are calculated by executing the aircraft-specification developing processing for each of the plurality of patterns of the design parameters.

By doing so, when changing the design parameters (Step 110 of the aircraft design processing), because the number of calculation results subjected to evaluation with respect to fitness with values of the constraints is increased, it is possible to achieve an optimal aircraft design with greater precision, even if the iterative processing is performed a small number of times.

A graph in Fig. 5(A) is a graph showing take-off weights of the aircraft calculated in the individual generations, where open circles (○) indicate calculation results that do not meet the constraints, whereas filled circles (●) indicate calculation results that meet the constraints. Graphic figures of 16 aircrafts in Fig. 5(B) indicate aircraft shapes calculated in the first generation, graphic figures of 16 aircrafts in Fig. 5(C) indicate aircraft shapes calculated in the 50th generation, graphic figures of 16 aircrafts in Fig. 5(D) indicate aircraft shapes calculated in the 300th generation, and, with these graphic figures of the individual aircrafts, the graphic figures having filled circles (●) on the upper-right-hand side thereof are those that meet the constraints.

As shown in (A) and (B) in Fig. 5, calculation in the first generation did not result in aircraft specifications that meet the constraints. In addition, the variability in take-off weights and shapes of the individuals is large in the first generation. However, more individuals that meet the constraints are created as the number of generations increases, for example, as indicated by the 50th generation shown in (A) and (C) in Fig. 5, and the variability in take-off weights and shapes of the individuals also decreases. Then, with the aircraft design processing according to this embodiment, once it becomes possible to calculate the aircraft specifications that meet the constraints, the take-off weights in the aircraft specifications that meet the constraints converge so that the take-off weights, which are the optimization targets, are decreased (300th generation shown in (A) and (D) in Fig. 5). Thus, the engineer can end the aircraft design processing by judging whether or not the take-off weights have converged by checking the calculation results of the aircraft design processing shown in Fig. 5 (Step 108 of the aircraft design processing), and he/she can select an optimal solution based on the converged results.

Note that the judgment of whether or not the conditions for ending the optimizing processing are met in Step 108 in Fig. 3 is not limited to judgment performed by the engineer; among other methods, for example, whether or not changes in the optimization target (take-off weight in this embodiment) between before and after one cycle fall within a range defined by thresholds set in advance may be judged or an approximation equation that approximates changes in the take-off weight in the aircraft specifications that meet the constraints may be calculated, and then, it may be judged whether or not the approximation equation is asymptotic to a certain value, and it may be judged that the conditions for ending the optimizing processing are met when such a judgment results in an affirmative judgment.

Furthermore, in addition to these, the judgment of whether or not the conditions for ending the optimizing processing are met may be performed by, among other methods, judging whether or not the iterative processing of the aircraft design program shown in Fig. 3 has been completed for the maximum number of times set in advance, and it may be judged that conditions for ending the optimizing processing are met in the case of an affirmative judgment.

Here, a concrete example of changing the design parameters executed in Step 110 in Fig. 3 will be described with reference to Fig. 5. As described above, the design parameters are changed based on the calculation results of the aircraft specifications that have previously been calculated so as to meet the optimizing conditions.

In the example in Fig. 5, in the earlier generations, the relationships between the design parameters and the constraints and the relationships between the design parameters and the take-off weight, which is the optimization target, are unknown, and it is not known whether or not the design parameters in question meet the constraints and also contribute to suppressing the take-off weight. Accordingly, in the example in Fig. 5, from the first to about the 20th generations, no individual that meets the constraints exists and the take-off weight, which is the optimization target, also changes in an increasing direction, which is the opposite of optimization. However, by repeatedly changing the design parameters and calculating the aircraft specifications, a trend in the design parameters that meet the constraints and that also suppress the take-off weight becomes clear, and, as a result, the take-off weight is decreased with an increasing number of generations, converging to a certain value that meets all constraints and optimizing conditions.

A diagram showing the calculation results of the aircraft design processing, such as one shown in Fig. 5, may be displayed on the image displaying part 22 in the case in which the iterative processing has been completed a predetermined number of times (for example, every fifty times) in the process of the iterative processing in the aircraft design processing or in the case in which an instruction is input by the engineer via the operation inputting part 20.

As has been described above, with the aircraft design apparatus 10 according to this embodiment, the aircraft specifications, which are aircraft specifications, are calculated based on the plurality of design parameters required to design an aircraft; it is judged whether or not the calculated aircraft specifications meet the given constraints and the given optimizing conditions for optimizing the aircraft; the design parameters are changed so that the calculated aircraft specifications meet the constraints and also meet the optimizing conditions; and the iterative processing in which the aircraft specifications are repeatedly calculated based on the changed design parameters is executed.

Therefore, with the aircraft design apparatus 10 according to this embodiment, it is possible to achieve a more optimal aircraft design. In addition, because an information processing device performs the above-described processing, the aircraft design apparatus 10 according to this embodiment makes it possible to reduce the time and effort required to design an aircraft.

In addition, with the aircraft design apparatus 10 according to this embodiment, because the design parameters are changed by means of the GA based on the calculation results of the aircraft specifications that have previously been calculated, the design parameters can be changed to more appropriate values as the number of calculation results of the aircraft specifications increases.

In addition, with the aircraft design apparatus 10 according to this embodiment, because the aircraft-specification developing processing calculates the aircraft specifications for a plurality of individuals each time the aircraft specifications are calculated, it is possible to achieve an optimal overall aircraft design with greater precision, even if the iterative processing is performed a small number of times.

In addition, with the aircraft design apparatus 10 according to this embodiment, because it is comprehensively judged whether or not the constraints related to the performance, aerodynamic characteristics, stability, landing gear, and structures of an aircraft, which are accounted for in an aircraft design, are met, it is possible to achieve a more realistic aircraft design.

As above, although the present invention has been described by using the embodiment described above, the technical scope of the present invention is not limited to the scope described in the embodiment described above. Various alterations and improvements can be incorporated into the embodiment described above within a range that does not depart from the scope of the invention, and the technical scope of the present invention also encompasses forms into which such alterations and improvements are incorporated.

For example, in the embodiment described above, although a form in which only one type of optimizing conditions is set in the aircraft design processing has been described, the present invention is not limited thereto, and a form in which multiple types of optimizing conditions are set may be employed. The form in this case can be realized by, for example, using a multi-objective optimization function of the GA, which makes it possible to optimize multiple types of aircrafts at the same time, and thus, it is possible to achieve optimal designs for an entire family of aircrafts suitable for different uses.

In addition, in the embodiment described above, although a form in which performance, aerodynamic characteristics, stability, landing gear, and structures of an aircraft are used as the constraints has been described, the present invention is not limited thereto, and, for example, a form in which other constraints, such as aircraft development cost, operating cost, etc., are used in combination may be employed.

In addition, in the embodiment described above, although a form in which a non-linear function is used to calculate the aircraft specifications has been described, the present invention is not limited thereto, and a form in which a linear function is used to calculate the aircraft specifications may be employed. In the case of this form, because it is not necessary to repeat calculation to determine a solution, the processing in Step 214 in Fig. 4 is not necessary.

In addition, in the embodiment described above, although a form in which the design parameters are changed by using the GA when changing the design parameters (Step 110 of the aircraft design processing) has been described, the present invention is not limited thereto, and a form in which other methods are used may be employed so long as the design parameters can be changed so that the calculated aircraft specifications meet the constraints and also meet the optimizing conditions.

In addition, in the embodiment described above, although a form in which the aircraft design program is stored in the HDD 18 has been described, the present invention is not limited thereto, and a form in which the aircraft design program is stored in the portable storage medium 26 may be employed.

In addition, the processing flow of the aircraft design program described in the embodiment described above is also merely an example, and unnecessary steps may be eliminated, new steps may be added, and the processing sequence may be switched within a range that does not depart from the scope of the present invention.

### {Reference Signs List}

10 aircraft design apparatus
12 CPU
18 HDD
20 operation inputting part

## Claims

1. An aircraft design apparatus comprising:
a calculating means that calculates aircraft specifications, which are aircraft specifications, based on a plurality of design parameters required to design an aircraft;
a first judging means that judges whether or not the aircraft specifications calculated by the calculating means meet given constraints;
a second judging means that judges whether or not the aircraft specifications calculated by the calculating means meet given optimizing conditions for optimizing the aircraft; and
a changing means that changes the design parameters,
wherein iterative processing is executed, in which the design parameters are repeatedly changed by the changing means and the aircraft specifications are repeatedly calculated by the calculating means based on the design parameters so that the aircraft specifications calculated by the calculating means meet the constraints and also meet the optimizing conditions.

2. An aircraft design apparatus according to Claim 1, wherein the first judging means judges whether or not constraints related to performance, aerodynamic characteristics, stability, a landing gear, and a structure of the aircraft are met.

3. An aircraft design apparatus according to Claim 1 or 2, wherein the changing means changes the design parameters so as to meet the optimizing conditions based on calculation results of the aircraft specifications that have previously been calculated by the calculating means.

4. An aircraft design apparatus according to any one of Claims 1 to 3, wherein the calculating means calculates the aircraft specifications for a plurality of individuals each time the aircraft specifications are calculated.

5. An aircraft design program that causes a computer to function as:
a calculating means that calculates aircraft specifications, which are aircraft specifications, based on a plurality of design parameters required to design an aircraft;
a first judging means that judges whether or not the aircraft specifications calculated by the calculating means meet given constraints;
a second judging means that judges whether or not the aircraft specifications calculated by the calculating means meet given optimizing conditions for optimizing the aircraft; and
a changing means that changes the design parameters,
wherein iterative processing is executed, in which the design parameters are repeatedly changed by the changing means and the aircraft specifications are repeatedly calculated by the calculating means based on the design parameters so that the aircraft specifications calculated by the calculating means meet the constraints and also meet the optimizing conditions.

6. An aircraft design method comprising:
a first step of calculating aircraft specifications, which are aircraft specifications, based on a plurality of design parameters required to design an aircraft;
a second step of judging whether or not the calculated aircraft specifications meet given constraints and given optimizing conditions for optimizing the aircraft; and
a third step of changing the design parameters so that the calculated aircraft specifications meet the constraints and also meet the optimizing conditions,
wherein iterative processing in which the aircraft specifications are repeatedly calculated based on the changed design parameters is executed.
